# EUROPEAN PATENT SPECIFICATION

(11) **EP 3 207 426 B1**
(45) Date of publication and mention of the grant of the patent: **09.10.2019**
(21) Application number: 15777971.1
(22) Date of filing: 13.10.2015
(51) Int. Cl.: G03F 9/00, B41J 11/00

(54) **PRINTING APPARATUS WITH ALIGNING ANCHOR AND SUBSTRATE HANDLING METHOD**
DRUCKGERÄT MIT AUSRICHTUNGSANKER UND SUBSTRATBEHANDLUNGSVERFAHREN
APPAREIL D' IMPRESSION AVEC ANCRE D'ALIGNEMENT ET PROCÉDÉ DE TRAITEMENT DE SUBSTRAT

(30) Priority: 15.10.2014 EP 14188929
(43) Date of publication of application: 23.08.2017
(73) Proprietor: OCE-Technologies B.V., 5914 CA Venlo (NL)
(72) Inventor: LANGE, Martinus G.M., NL-5914 CA Venlo (NL); OTTEN, Niek, NL-5914 CA Venlo (NL)
(74) Representative: OCE IP Department
(86) International application number: PCT/EP2015/073615
(87) International publication number: WO 2016/059016

(56) References cited:
- EP-A1- 0 529 944
- US-A- 5 300 973
- US-A1- 2001 022 652
- US-A1- 2002 011 164
- US-A1- 2007 002 303

## Description

### FIELD OF THE INVENTION

The present invention relates to a printing apparatus for providing an image on a substrate, comprising an aligning anchor for positioning the substrate on a printing surface of the printing apparatus. The present invention further relates to a method of positioning a substrate on a printing surface using the aligning anchor.

### BACKGROUND ART

A known flatbed printing apparatus comprises a vacuum table and a gantry. Such a flatbed printing apparatus is well known in the art, such as an Oce ® Arizona 550. Said vacuum table comprises a printing surface. Said gantry is arranged for supporting and guiding a carriage. For example, the gantry may be moved in a y-direction and the carriage may be moveably supported by the gantry such that the carriage may be moved in a x-direction guided by the gantry over the printing surface. The carriage is provided with a printing element, such as an inkjet print head, arranged at a predetermined print gap height from a substrate, which is arranged on the printing surface, for printing an image on the substrate by ejecting ink drops in a printing area at predetermined positions.

The printing surface is adapted for holding the printing substrate stationary in the printing area during printing operation. The printing surface comprises a plurality of suction holes, wherein each suction hole is arranged in fluid communication to a suction device, and wherein the suction device in printing operation provides a suction pressure to each of the plurality of suction holes.

In the known flatbed printer a substrate, such as a rigid panel, is manually mounted on the printing surface. After the substrate is mounted on the printing surface, the substrate is fixed to the printing surface by providing a suction pressure at each suction hole of the printing surface. In order to accurately position the substrate on the printing surface a ruler may be provided on the vacuum table, for example by printing a guide on an edge portion of the vacuum table. The operator may manually align the printing substrate on the printing surface with respect to the ruler.

A disadvantage is that said ruler is only provided along the edge portion of the vacuum table. Although the vacuum table has one size, the substrates that are processed can have multiple sizes. A demand exists for accurately positioning a substrate anywhere on the vacuum table. Furthermore a plurality of substrates having smaller sizes may be mounted on the printing surface at the same time, wherein each of the plurality of substrates must be accurately positioned independently. Another disadvantage is that manually aligning a rigid panel on a printing surface is time consuming and does not easily result in an accurate alignment of the substrate with respect to the printing directions of the printing apparatus.

US 2001/022652 A1 discloses an intermediate substrate holder for use in a lithographic projection apparatus, which holder can itself be held by a standard substrate holder in said lithographic projection apparatus and in turn can hold a non-standard substrate. The means for holding the non-standard substrate may be comprised of one of or both of a vacuum holding means and mechanical clamping means. The vacuum holding means may be comprised of: a vacuum space on which the non-standard substrate is placed; a barrier means around the edge of the vacuum space that closes off the vacuum space and that makes a sealing contact with the non-standard substrate; and a means for exposing the vacuum space to vacuum. The mechanical clamping means may be comprised of: two or more stationary positioning pins opposed by a slidable mechanism which is provided with at least one sliding positioning pin mounted thereon and which is biased to move the sliding positioning pin towards the stationary pins.

It is an object of the present invention to provide a tooling and a method for easily and accurately positioning a substrate anywhere on a printing surface of a printer apparatus.

### SUMMARY OF THE INVENTION

This object is attained by providing a printing apparatus for providing an image on a substrate, the printing apparatus comprising a printing surface for supporting the substrate in a printing area and an aligning anchor for positioning the substrate on the printing surface, the printing surface comprising a plurality of suction holes being distributed over the printing surface to provide a suction force to a contact side of the substrate, the aligning anchor comprising:
a first aligning element comprising a contact surface shaped to contact the printing surface, wherein the first aligning element has a thickness perpendicular to the contact surface; and
wherein the aligning anchor further comprises a first positioning pin and a second positioning pin, each positioning pin protruding in a height direction substantially perpendicular from the contact surface and being shaped to fit into a suction hole, the first positioning pin and the second positioning pin being arranged at a distance with respect to each other in the plane of the contact surface such that the first positioning pin fits into a first suction hole of the printing surface while the second positioning pin fits into a second suction hole of the printing surface in an assembled state of the aligning anchor and the printing surface.

The aligning anchor comprises a first positioning pin and a second positioning pin, which pins are cooperatively arranged protruding from the plane of the contact surface such that the first positioning pin may be fitted into a first suction hole of the printing surface while the second positioning pin fits into a second suction hole of the printing surface. Each positioning pin is shaped to fit into a suction hole. When the positioning pin is fitted into a suction hole of the printing surface the contact surface of the first aligning element is supported on the printing surface.
By cooperatively fitting the first positioning pin and the second positioning pin into a respective suction hole, the position of the aligning anchor on the print surface is accurately determined. A thickness of the first aligning element perpendicular to the contact surface first aligning element defines an alignment edge to align an edge of the substrate. The substrate may be positioned on the printing surface by aligning an edge of the substrate in contact with the alignment edge of first aligning element.
The aligning anchor may be accurately positioned on a large number of positions along the printing surface, as a common printing surface may comprise a regular pattern of suction holes. A pattern of suction holes may comprise a plurality of rows of suction holes, such as a row of suction holes extending in one of the printing directions. Such a printing direction may for example be the moving direction of the carriage and may be the moving direction of the gantry. Each row of suction holes provides a large number of positions for positioning the aligning anchor.

In an embodiment of the aligning anchor, the first aligning element comprises a first alignment edge disposed at one end of the contact surface, the first alignment edge extending in a first direction and being shaped to accommodate a first edge of the substrate along a first contact line. Said first alignment edge may be conformed in part or completely to the first edge of the substrate. The advantage is that aligning the substrate along the first contact line is simple and accurate. For example said first alignment edge may have a straight shape, wherein an edge of a rectangular substrate, having four straight edges, may be accurately positioned in contact to said first alignment edge along said contact line.
The substrate may be manually and accurately positioned in one direction by urging the first edge of the substrate against the first alignment edge of the aligning anchor.

In embodiments, each of the positioning pins has a protruding part having a diameter in the plane of the contact surface, which is equal to a diameter of the suction hole in the plane of the contact surface or which is smaller than a diameter of the suction hole in the plane of the contact surface. For example a diameter of the protruding part being at most 5 mm is suitable to fit in suction holes of printing surfaces having a diameter of 5 mm. Suction holes to attract a substrate to a printing surface typically have a substantially circular shape, which has a diameter of about 5 mm, more preferably less than 2 mm, in order to provide a suitable suction force to a contact side of the substrate. In case the diameter of the protruding part of the positioning pins exceeds the diameter of the suction holes, said positioning pins do not fit into the respective suction holes.

In an embodiment of the aligning anchor, each of the first positioning pin and the second positioning pin have a protruding part, which protruding part is conformed to substantially shut the respective suction hole of the printing surface in an assembled state of the aligning anchor and the printing surface. Said protruding parts provide a fixation of the position of the aligning anchor onto the printing surface. Furthermore said aligning anchor may be held on to the printing surface by providing a vacuum pressure in the respective suction holes. Said protruding part may have a diameter which is substantially equal to a diameter of the respective suction hole (upper limit +/- 0.1 mm difference between diameters).

In an embodiment the diameter of said protruding part is smaller than the diameter of the suction hole in the plane of the contact surface, thereby providing a backlash of the protruding part relative to the suction hole in the plane of the contact surface. Said backlash may be selected to provide a tolerance for a mismatch of the distance between the positioning pins relative to a distance between the first suction hole and the second suction hole, both distances being in the plane of the contact surface. Accurate positioning of the first aligning element (and the alignment edge) and the substrate on the printing surface is achieved by urging the protruding parts of the positioning pins against the suction holes in a direction perpendicular to the alignment edge. The positioning is supported by accurate positions the first positioning pin and second positioning pin with respect to the alignment edge.

The first aligning element has a thickness, which thickness is perpendicular to the contact surface. Said thickness may be suitably selected between a lower limit to form an alignment edge to align the substrate and a higher limit to substantially not obstruct a printing element from facing the substrate, such as a printing element being arranged at a predetermined print gap height.

In an embodiment the first aligning element has a thickness, which thickness is perpendicular to the contact surface, wherein the thickness is at most equal to a predetermined print gap height. Generally known printing gap heights for inkjet printing on substrates are in the range of 1 - 5 mm. For a known printing system the predetermined print gap height is known as such from the control unit of the printing system. As a result the aligning anchor does not obstruct a movement of any print elements, such as inkjet print heads, over the substrate in the assembled state. The advantage is that the aligning anchors may be retained in the assembled state on the print surface during any printing operations, such as inkjet printing, on the substrate. The contact surface supports on the printing surface in said assembled state.

In another embodiment the first aligning element has a thickness, which thickness is perpendicular to the contact surface, wherein the thickness is at most equal to the sum of the thickness of the substrate plus a predetermined print gap height.
In case the printing elements in the printing system are arranged at a height above the printing surface which is equal to the sum of the thickness of the substrate plus the predetermined print gap height, a higher limit of the thickness may be equal to said sum of the thickness of the substrate plus the predetermined print gap height. The thickness of the substrate may be detected by the printing system or the thickness of the substrate may be entered into the control unit of the printing system by the operator.

In another embodiment the first aligning element has a thickness, which thickness is perpendicular to the contact surface, wherein the thickness is at most substantially equal to the thickness of the substrate. In this embodiment the higher limit of the thickness of the first aligning element is substantially equal to the thickness of the substrate. The thickness of the substrate may be detected by the printing system of the thickness or the substrate may be entered into the control unit of the printing system by the operator. As a result the first aligning element does substantially not protrude in the height direction from the substrate in the assembled state perpendicular to the printing surface. This prevents obstruction of a movement of print elements, even in case the print gap height is substantially close to zero.

In an embodiment of the aligning anchor, the first positioning pin is movable into a plurality of positions in the plane of the contact surface to adjust the distance between the first positioning pin and the second positioning pin, wherein the aligning anchor comprises at least one recess arranged to retain said first positioning pin in each of said plurality of positions. By moving the first positioning pin the distance between the first positioning pin and the second positioning pin is adjusted. As a result the first positioning pin and the second positioning pin may be arranged to cooperatively fit in any suction hole of a print surface. For example several print surfaces may comprise various arrays of suction holes, wherein a distance between suction holes differ. Furthermore by changing the distance between the first positioning pin and the second positioning pin said aligning anchor may be positioned at another angle with respect to an array of suction holes, while fitting the positioning pins in respective suction holes. Another advantage is that arranging the positioning pins to fit in respective suction holes is flexible to compensate small variations in distance between said suction holes. For example when a print surface warms up, a distance between suction holes may change due to thermal expansion of the print surface.

In an embodiment of the aligning anchor, said at least one recess comprises a groove to guide said first positioning pin between each of said plurality of positions. Said groove provides a simple means to movably arrange the first positioning pin along the groove. In an alternative embodiment said at least one recess comprises a plurality of pockets arranged at said plurality of positions. Said plurality of pockets is a suitable embodiment in case distances between respective suction nozzles are accurately controlled and predetermined.

In an embodiment of the aligning anchor, the aligning anchor further comprising a second aligning element comprising a second contact surface shaped to contact the printing surface, the second aligning element comprising a second alignment edge disposed at one end of the second contact surface, the second alignment edge extending in a second direction and being shaped to accommodate a second edge of the substrate along a second contact line, wherein the second direction is arranged at an angle to the first direction.
Said aligning anchor may be used to align two edges of the substrate at once, thereby positioning the substrate in two directions. For example each alignment edge may be arranged substantially perpendicular to one of the printing directions (e.g. perpendicular to a x-direction of a scanning carriage or to a y-direction of the moving gantry).
The second contact surface may be adjacent to the contact surface of the first aligning element. In an alternative embodiment the second contact surface may be arranged distant from the contact surface of the first aligning element
In an alternative embodiment the substrate may be positioned in several directions by using a plurality of aligning anchors, each providing an alignment edge being arranged at an angle with respect to each other.

In an embodiment of the aligning anchor, said first positioning pin is disposed in the contact surface of said first aligning element and said second positioning pin is disposed in the second contact surface of said second aligning element. Said aligning anchor enhances a rigid structure to position the first and second aligning element.

In another embodiment of the aligning anchor, the aligning anchor comprises a first aligning element and a second aligning element, each of the two aligning elements comprising a contact surface shaped to contact the printing surface and comprising two alignment edges disposed at both ends of the contact surface opposite to one another, the two alignment edges extending substantially in parallel to one another, wherein the two aligning elements are arranged intersecting one another, thereby forming a substantially cross shape in the plane of the contact surfaces.
The aligning anchor has the advantage that four rectangular substrates may be aligned with respect to the alignment edges in the assembled state of the aligning anchor and the printing surface and may be aligned with respect to the four corners of the cross shaped aligning anchor. A corner is defined by the two aligning elements at the intersecting position of the two aligning elements. Preferably each of the corners has an angle of about 90 degrees in order to accommodate the corner of a rectangular substrate.

In an embodiment of the aligning anchor, the aligning anchor further comprises a handle element, which handle element is adapted for manually positioning the aligning anchor onto the printing surface and/or manually removing the aligning anchor from the printing surface. Said handle element provides an easy way for manually positioning and/or removing the aligning anchor on the printing surface.
In an alternative embodiment the first aligning element comprises a recess arranged at the contact surface adjacent to a side of the first aligning element, which recess is shaped for removing the aligning anchor from the printing surface. By arranging a flat tip, such as a fingernail, in the recess, the aligning anchor may be easily removed from the printing surface.

In an embodiment of the aligning anchor, the handle element comprises a flexible lip, which flexible lip extends substantially parallel to the contact surface. The flexible lip is bendable at a loose end. Said flexible lip may be connected to the first aligning element. The aligning anchor may be removed from the printing surface by bending the flexible lip in a direction opposite to the protruding direction of the positioning pins and pulling the aligning anchor at the flexible lip away from the printing surface.

In an embodiment of the aligning anchor, the handle element is detachable from the aligning anchor. Said handle element may be disconnected from the first aligning element during use of the aligning anchor in the assembled state on the printing surface. The handle element provides a manual handle for positioning the aligning anchor while the handle element does not obstruct any print elements, such as inkjet print heads, in an assembled state of the aligning anchor and the printing surface. In a particular embodiment said handle element comprises a magnetic portion adapted to magnetically attach the handle element to the aligning anchor.

In an embodiment of the aligning anchor, the first aligning element comprises a cavity arranged at the contact surface to form a vacuum chamber arranged in fluid communication to a third suction hole of the printing surface in an assembled state of the aligning anchor and the printing surface. The cavity provides a simple means to fix the aligning anchor on the printing surface during printing operation of a printing apparatus wherein a suction pressure is provided in each suction hole.

In an embodiment of the aligning anchor, the aligning anchor comprises a magnetic portion to magnetically attract the aligning anchor to the printing surface. The magnetic portion enhances a fixing of the aligning anchor to the printing surface in case the printing surface contains a magnetic component.

In another aspect of the invention a printing apparatus is provided, wherein each suction hole is arranged in fluid communication to a suction device, which is configured to provide a suction pressure to each of the plurality of suction holes; wherein the printing apparatus comprises a printing station comprising a print head assembly arranged at a predetermined print gap height and configured to apply ink dots on the substrate in the printing area; wherein the contact surface is arranged in contact with the printing surface and wherein each positioning pin of the aligning anchor is arranged in a respective suction hole of the printing surface, thereby determining a position of the aligning anchor with respect to the printing surface.
A substrate may easily be aligned on the printing surface of the printing apparatus by urging a respective edge of the substrate against the aligning anchor. The aligning anchor may remain in the assembled state on the printing surface during printing on the substrate.

In an embodiment of the printing apparatus, the aligning anchor has a marked part, wherein the printing apparatus further comprises a sensor device, which is configured to detect the marked part of the aligning anchor on the printing surface and to provide a detection signal to a control unit, which is configured to derive the position and/or size of the substrate on the printing surface based on the detected position of the aligning anchor and is configured to control the printing of the image on the substrate based on the determined position and/or size of the substrate.
Said marked part may be formed by a colored part, a patterned part, a QR-code part, a barcode part, or any other suitable marked part to be detected by the sensor device for deriving the position and/or size of the substrate on the printing surface

In an embodiment of the printing apparatus, the printing apparatus further comprises a docking station for keeping the aligning anchor, wherein the docking station comprises a docking surface for supporting the contact surface of the aligning anchor and a plurality of holes arranged for accommodating the first positioning pin and the second positioning pin of the aligning anchor in an assembled state of the aligning anchor and the docking surface. The docking station has the advantage that aligning anchors may be retained safely at the printing apparatus and the aligning anchors are close at hand for positioning on the printing surface.

In another aspect of the invention a method is provided of handling a printing substrate on a printing surface, the method comprising the steps of:
a) Providing a printing apparatus according to the present invention;
b) Positioning the aligning anchor onto the printing surface, thereby supporting the contact surface on the printing surface and fitting each of the first and second positioning pins of said aligning anchor in a respective suction hole of the printing surface; and
c) Positioning the substrate on the printing surface, comprising supporting a contact side of the substrate on the printing surface and urging a respective edge of the substrate against the aligning anchor.

In the positioning step of the aligning anchor the contact surface is supported on the printing surface and each of said first and second positioning pins is fitted in a respective suction hole.

In the positioning step of the substrate an edge of the substrate is urged against a respective alignment edge of an aligning anchor which is positioned on the printing surface.

In an embodiment of the method, the method comprises a further step of: applying an inkjet image on the substrate by moving a print head assembly over the substrate at a predetermined print gap height with respect to the substrate.

In an embodiment of the method, the method comprises the steps of: positioning a plurality of aligning anchors onto the printing surface and positioning a plurality of substrates on the printing surface, comprising supporting a respective contact side of the substrate on the printing surface and urging a respective edge of the substrate against one of the plurality of aligning anchors.

The advantage is that after positioning the plurality of substrates on the printing surface, said plurality of substrates may be processed in one printing operation.

In a further embodiment, the method comprises a further step of: applying an inkjet image on each of the plurality of substrates by moving a print head assembly over the substrate at a predetermined print gap height with respect to the plurality of substrates.

Further scope of applicability of the present invention will become apparent from the detailed description given hereinafter. However, it should be understood that the detailed description and specific examples, while indicating embodiments of the invention, are given by way of illustration only, since various changes and modifications within the scope of the invention will become apparent to those skilled in the art from this detailed description.

### BRIEF DESCRIPTION OF THE DRAWINGS

Hereinafter, the present invention is further elucidated with reference to the appended drawings showing non-limiting embodiments and wherein
- Fig. 1A: shows a perspective view of a flatbed inkjet printing device.
- Fig. 1B: schematically illustrates a flatbed inkjet printer provided with radiation sources.
- Figs. 2A - 2E: show an aligning anchor according to an embodiment of the present invention.
- Figs. 3A - 3C: show an aligning anchor according to another embodiment of the present invention.
- Fig. 3D: shows an alternative embodiment of the aligning anchor of Figs. 3A-3C.
- Figs. 4A - 4B: show the aligning anchor of Figs. 3A-3C in two assembled states on a printing surface.
- Fig. 5: shows an aligning anchor according to another embodiment of the present invention.
- Fig. 6: shows an aligning anchor according to another embodiment of the present invention.
- Fig. 7: shows an aligning anchor according to another embodiment of the present invention in an assembled state on a printing surface.
- Fig. 8: shows an aligning anchor according to another embodiment of the present invention in an assembled state on a printing surface.

### DETAILED DESCRIPTION OF EMBODIMENTS

The present invention will now be described with reference to the accompanying drawings, wherein the same reference numerals have been used to identify the same or similar elements throughout the several views.

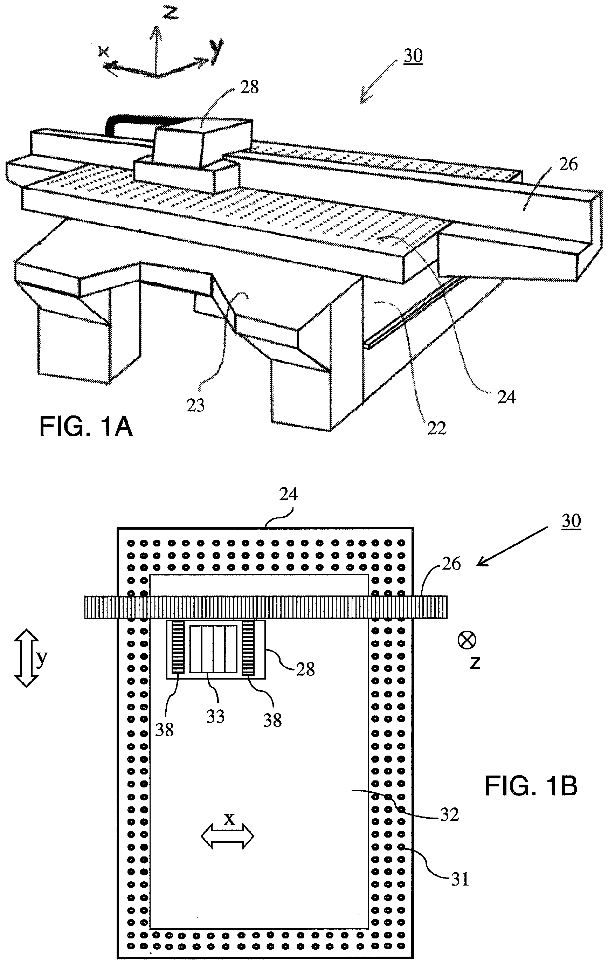

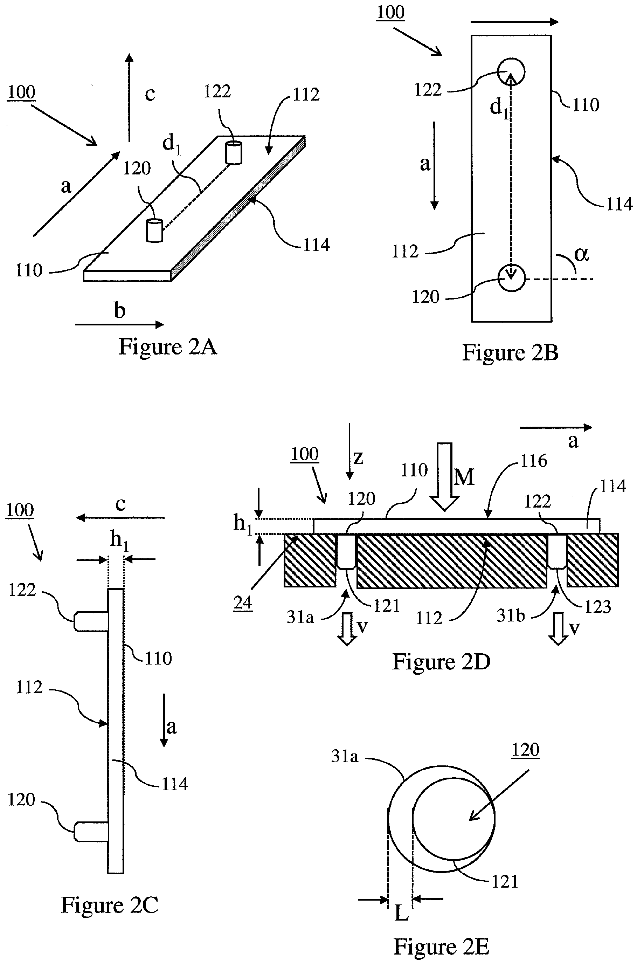

Fig. 1A shows a flatbed UV inkjet printing device 30 for printing an image or text on a relatively large object, in particular on a relatively large and flat object. Such a printing device 30 is well known in the art, such as an Oce ® Arizona 550. The printing device 30 comprises a support assembly 22 on which a printing surface 24 is arranged. As illustrated, the printing surface 24 may be provided with suction holes for pulling the object onto the printing surface 24 and thereby holding the object flat on the printing surface 24. A guiding assembly 26 is provided for supporting and guiding a carriage 28. The carriage 28 is movably supported by the guiding assembly 26 such that the carriage 28 may be moved over the printing surface 24. For example, the guiding assembly 26 may be movably supported on the support assembly 22 such that the guiding assembly may be moved in a y-direction (as indicated in Fig. 2A) and the carriage 28 may be moveably supported by the guiding assembly 26 such that the carriage may be moved in a x-direction guided by the guiding assembly 26. The carriage 28 is provided with a printing element such as an inkjet printhead for printing the image or the text on the object arranged on the printing surface 24 by ejecting ink drops at predetermined positions. It is noted that the guiding assembly 26 and / or the carriage 28 may be supported such that they may be moved in a z-direction, thereby arranging the printing element at a predetermined print gap height (in the z-direction) relative to a receiving member 32 and enabling to print on different media 32 (i.e. objects) having a different height in the z-direction (when positioned on the printing surface 24).

Fig. 1B schematically shows the flatbed UV inkjet printing device 30 when viewing the device 30 in Fig. 1A in z-direction from above. In Fig. 1B the printing surface 24 comprises suction holes 31. The printing surface 24 supports and fixes an image receiving member 32. Several print heads, may be mounted on the carriage (28) which can be moved in reciprocation along the guiding assembly 26 extending across the image-receiving member, i.e. the main scanning direction. The print heads (33) are arranged at a predetermined print gap height of 1.5 mm above the printing surface 24. The print heads (33) of a particular color, e.g. black (K), cyan (C), magenta (M), yellow (Y), are arranged in the main scanning direction. Each print head comprises a number of discharging elements which are typically arranged in a single array or in multiple arrays in the sub scanning direction. Each discharging element is connected via an ink duct to an ink reservoir of the corresponding colour. Each ink duct is provided with means for activating the ink duct and an associated electrical drive circuit. For instance the ink duct may be activated thermally, and/or piezoelectrically, or acoustic, or electrostatically. When the ink duct is activated an ink drop is discharged from the discharge element in the direction of the printing surface (24) and forms a dot of ink on the image-receiving member. The carriage further supports two radiation sources (38) for irradiating the ink dots deposited on the image-receiving member. This guiding assembly 26 can be moved back and forth along the image-receiving member, i.e. in the sub scanning direction. The image receiving membrane 32 is kept stationary on the printing surface 24.
The radiation sources (38) irradiate at least the ink dots deposited during the print swath. The radiation sources, in casu L-shaped xenon flash lamps, are mounted to both sides of the carriage in such a way that all the ink jetted onto the image-receiving member is exposed to the radiation. The print heads are shielded to prohibit undesired exposure to UV irradiation. At the end of each print swath, the lamp positioned upstream with respect to the print heads is instantly switched off when crossing the edge of the image-receiving member or the printing surface 24 to avoid reflections from and/or heating up of the printing surface 24. Subsequently in the reciprocating movement the same lamp is instantly switched on and when reaching the opposite edge of the image-receiving member the other lamp is switched off. By doing so print quality degradation due to undesired UV back reflections or warming up of the image-receiving member is avoided or at least severely limited.

Figs. 2A - 2E show an aligning anchor according to an embodiment of the present invention. Fig. 2A shows the aligning anchor 100 comprising a first aligning element 110, which comprises a contact surface 112 and an alignment edge 114, a first positioning pin 120 and a second positioning pin 122. The contact surface 112 extends in a first direction as indicated by arrow a. Said contact surface 112 has a substantially flat shape to contact a printing surface in case the contact surface 112 is supported on the printing surface. The first aligning element 110 may be a metal sheet, a plate or any other thin element having a substantially flat contact surface 112. A thickness h₁ of the first aligning element 110 in a direction as indicated by arrow c (as shown in Fig. 2C) is at most 10 mm.

The alignment edge 114 is disposed at a side of the contact surface 122 and extends along the first direction (a), as is shown in Fig. 2B. The alignment edge 114 is shaped to provide a contact to an edge of a substrate along a contact line. Preferably the alignment edge 114 is shaped along a straight line to contact an edge of a rectangular substrate. The alignment edge 114 has the same thickness h₁ as first aligning element 110.
The first positioning pin 120 and the second positioning pin 122 protrude in a height direction as indicated by arrow c from the contact surface 110 (Figs. 2A and 2C). Both first positioning pin 120 and the second positioning pin 122 are arranged inside the plane of the contact surface 110 (Fig. 2B). The first positioning pin 120 and the second positioning pin 122 are arranged at a distance with respect to each other in the plane of the contact surface 110 as indicated by arrow d₁.The distance d₁ is selected such that the first positioning pin 120 fits into a first suction hole 31a of the printing surface while the second positioning pin 122 fits into a second suction hole 31b of the printing surface 24 in an assembled state of the aligning anchor 100 and a printing surface 24, as is shown in Fig. 2D.
The first positioning pin 120 and the second positioning pin 122 are arranged on a line substantially parallel to the first direction (a). The alignment edge 114 is also arranged on a line substantially parallel to the first direction (a) and is arranged offset relative to the first positioning pin 120 and the second positioning pin 122 in a lateral direction as indicated by arrow b, which lateral direction b is perpendicular to the first direction a. The alignment edge 114 has an angle α relative to the lateral direction (b) as shown in Fig. 2B, wherein the angle α shown is 90 degrees. In alternative embodiments the angle α may be smaller than 90 degrees.

Fig. 2D shows the assembled state of the aligning anchor 100 on the printing surface 24. Fig. 2D is a view along a cross section line intersecting the first positioning pin 120 and the second positioning pin 122 and intersecting a first suction hole 31a and second suction hole 31b of the printing surface 24 perpendicular to the printing surface 24. Each of the positioning pins 120, 122 have a protruding part 121,123 which fit into the respective suction holes 31a, 31b.
The aligning anchor 110 is positioned on the printing surface 24 as indicated by arrow M by supporting the contact surface 112 on the printing surface 24 and fitting the first positioning pin 120 into the first suction hole 31a of the printing surface 24 and fitting the second positioning pin 122 into the second suction hole 31b of the printing surface 24. In this example the thickness of the first aligning element h₁ is at most 1.5 mm, which is equal to the predetermined print gap height of the Oce ® Arizona 550. As a result the aligning anchor 110 does not obstruct a movement of any print elements over the substrate in the assembled state. The advantage is that the aligning anchor 110 may be retained in the assembled state on the print surface during any printing operations on the substrate. In case the predetermined print gap height of the printing system differs, the thickness of the first aligning element h₁ may accordingly be adapted based on the predetermined print gap height.
The first positioning pin 120 and the second positioning pin 122 in this example are conformed to the respective suction holes 31a, 31b. Each of the protruding parts 121, 123 substantially shuts the respective suction hole 31a, 31b.
In the assembled state shown a suction force may be provided through the suction holes 31a, 31b as indicated by arrows v, wherein the suction force (v) fixates the aligning anchor 100 onto the printing surface 24.

Fig. 2E shows an enlarged cross section view of an alternative embodiment of the positioning pin 120 of the aligning anchor 100 being fit into a suction hole 31a in the assembled state on the printing surface 24 as shown in Fig. 2D. The cross section view is in the plane of the printing surface 24. The positioning pin 120 comprises a protruding part 121, which is accommodated inside the suction hole 31a. The protruding part 121shown has a substantially circular shape in the plane of the printing surface 24as well as the suction hole 31a has a substantially circular shape in the plane of the printing surface 24. A diameter of the protruding part 121 in the example shown is smaller than a diameter of the suction hole 31, both in the plane of the printing surface 24, thereby providing a backlash L of the protruding part 121 relative to the suction hole 31a. In the example shown the protruding part 121 is cylindrical shaped, having a constant diameter along its protruding length. Said backlash L may be selected to provide a tolerance for a mismatch of the distance between the positioning pins d₁ relative to a distance between the first suction hole and the second suction hole, both distances being in the plane of the contact surface 112. In this alternative embodiment the first positioning pin 120 and the second positioning pin 122 may position the alignment edge 114 by obstructing the movement of the aligning anchor along the printing surface at the moment a substrate is urged against the alignment edge 114. In the embodiment as shown in Fig. 2D, said backlash L may be substantially zero and the protruding part 121 substantially shuts the suction hole 31a.

The aligning anchor 100 may in an embodiment further comprise a marked part, such as a colored part or a patterned part, which marked part is arranged on an upper side 116 of the first aligning element 110. Said marked part may be formed by a colored part, a patterned part, a QR-code part, a barcode part, or any other suitable marked part to be detected by the sensor device for deriving the position and/or size of the substrate on the printing surface
In the assembled state shown in Fig. 1D said marked part may be detected by a sensor device (not shown), which is provided in a printing apparatus, such as the printing apparatus shown in Fig. 1A-1B, being arranged facing the printing surface 24. Said sensor device is configured to detect the marked part on the aligning anchor 100 and to provide a detection signal to a control unit of the printing apparatus. Said control unit is configured to derive the position and/or size of the substrate on the printing surface 24 based on the detected position of at least one aligning anchor 100 in an assembled state on the printing surface 24. The control unit may control the printing of an image on the substrate based on the determined position and / or size of the substrate. An example of a printing system being having a sensor device, such as a camera system, and a control unit suitable to detect a marked part and control the printing of an image on the substrate according to this embodiment is described in copending application PCT/EP2014/063327.

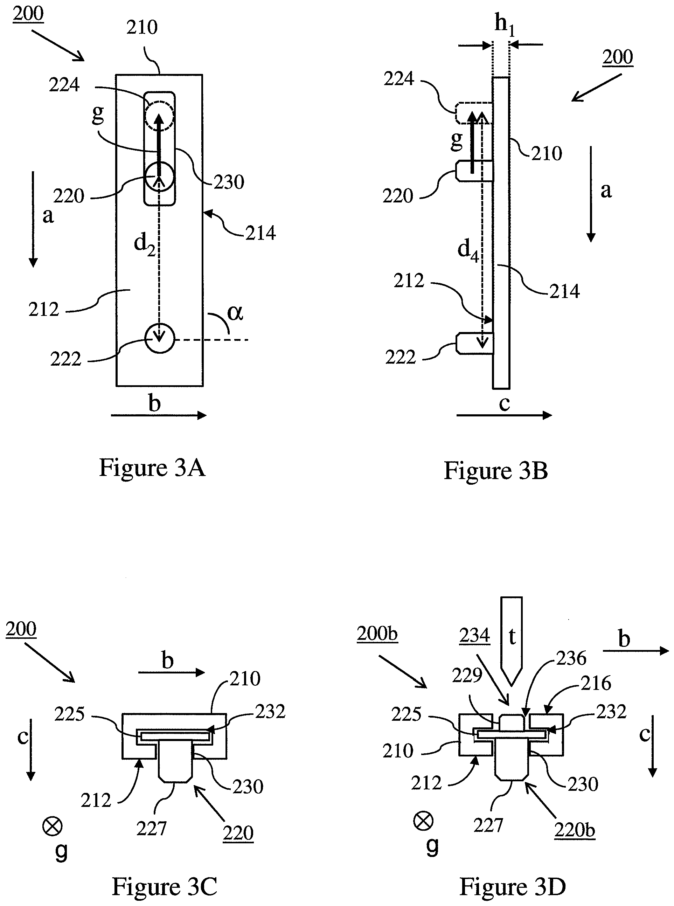

Figs. 3A - 3D show an aligning anchor according to another embodiment of the present invention. The aligning anchor 200 comprising a first aligning element 210, a first positioning pin 220 and a second positioning pin 222. The first aligning element 210 comprises a contact surface 212, an alignment edge 214 and a groove 230. The first positioning pin 220 and the second positioning pin 222 are arranged at a distance with respect to each other in the plane of the contact surface 210 as indicated by arrow d₂.The first positioning pin 220 is movably arranged inside the groove 230 in the plane of the contact surface 212. The first positioning pin 220 may be moved along the groove to another position as indicated by positioning pin 224. The groove 230 extends in the first direction as indicated by arrow a. The groove 230 guides the first positioning pin 220 along the guiding direction as indicated by arrow g.
The first positioning pin 224 in the second position is arranged at a distance d₄ from the second positioning pin 222 (as shown in Fig. 3B), wherein said distance d₄ is larger than the distance d₂ between the first positioning pin 220 in the first position and the second positioning pin 222.

Fig. 3C shows the aligning anchor 200 along a cross section of the groove 230 perpendicular to the guiding direction g thereby intersecting the first positioning pin 220. The groove 230 extends in a direction perpendicular to the plane of viewing. The first positioning pin 220 comprises a protruding part 227, which protrudes from the contact surface 212, and a plate like part 225. The plate like part 225 is enclosed by the first aligning element 210 inside a cavity 232, which cavity 232 is connected to the groove 230 and extends broader relative to the groove 230 in the lateral direction b. The plate like part 225 retains the first positioning pin 220 substantially stationary in the direction c.

Fig. 3D shows a view of an alternative embodiment of the aligning anchor 200b along a cross section of the groove 230 perpendicular to the guiding direction g thereby intersecting a first positioning pin 220b. The aligning anchor 200b is a modified embodiment of the aligning anchor 200 shown in Figs. 3A-3C.
The aligning anchor 200b comprises a through hole 234, which includes the groove 230 and cavity 232 shown in Figs. 3A and 3C and additionally comprises a groove 236. The groove 236 is connected to the cavity 232 and is arranged parallel to the groove 230 at an upper side 216 of the first aligning element 210. The first positioning pin 220b comprises the protruding part 227, the plate like part 225 and additionally a handle part 229.
Said handle part 229 is a pin, which does not substantially extend beyond the upper surface 216. The pin 229 has a diameter smaller than the groove 236 in the lateral direction b. Said pin 229 may comprise a hole. Said pin 229 may be handled by a separate handle element (as indicated by arrow t) to move the first positioning pin 220 along the groove 230 in the plane of the contact surface 212. The through hole 234 has the advantage that the position of the first positioning pin 220 is detectable from the upper surface 216 of the first aligning element 210. The handle part 229 has the advantage that the position of the first positioning pin 220 along the groove 230 may be easily controlled from the upper side 216 of the aligning anchor 200b. This provides an advantage when assembling the aligning anchor 200b and a printing surface 24.

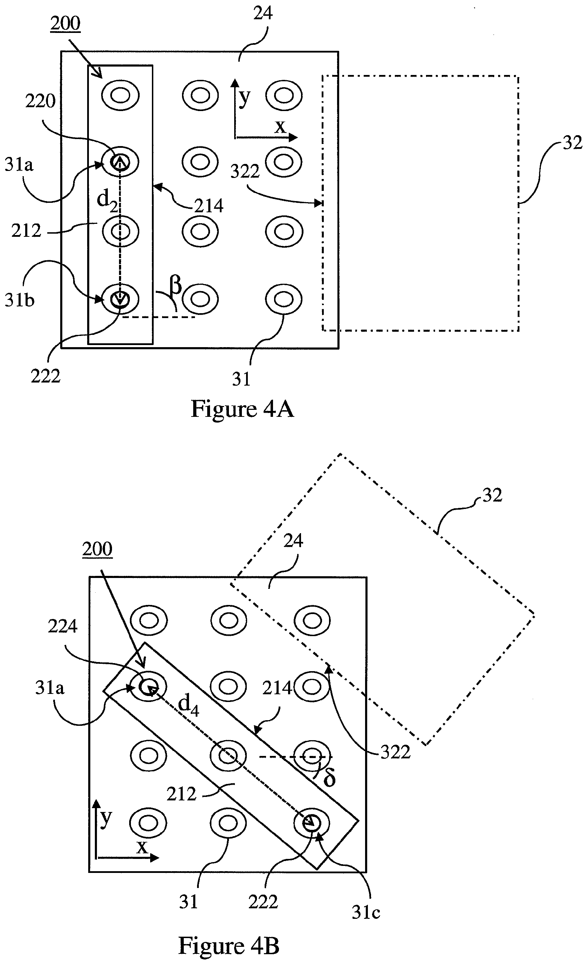

Figs. 4A-4B show two assembled states of the aligning anchor of Figs. 3A-3B on a printing surface, printing surface 24 comprises a regular array of suction holes 31, which array comprises a plurality of rows of suction nozzles 31 arranged in a carriage moving direction as indicated by arrow x. Said rows of suction nozzles 31 is distributed in a guiding assembly moving direction as indicated by arrow y (see also Fig. 1B). Figs. 4A-4B show a cross section of the aligning anchor 200 along the printing surface 24.

Fig. 4A shows a first assembled state of the aligning anchor 200 on the printing surface 24. In Fig. 4A the aligning anchor 200 is positioned on the printing surface 24, by supporting the contact surface 212 on the printing surface 24, arranging the first positioning pin 220 at a distance d₂ with respect to the second positioning pin 222, and subsequently fitting the first positioning pin 220 in suction hole 31a and fitting second positioning pin 222 in suction hole 31b. The distance d₂ is equal to the distance between the suction hole 31a and 31b. The alignment edge 214 is in the first assembled state arranged substantially parallel to the direction y. The angle β of the alignment edge 214 with respect to the x direction is substantially 90 degrees. A substrate 32 may be positioned in the x direction on the printing surface 24 by urging an edge 322 of the substrate 32 against said alignment edge 214.

Fig. 4B shows a second assembled state of the aligning anchor 200 on the printing surface 24. In Fig. 4B the aligning anchor 200 is positioned on the printing surface 24, by supporting the contact surface 212 on the printing surface 24, arranging the first positioning pin 224 at a distance d₄ with respect to the second positioning pin 222 being larger than the distance d₂ shown in Fig. 4A, and subsequently fitting the first positioning pin 224 in suction hole 31a and fitting the second positioning pin 222 in suction hole 31c. The distance d₄ is equal to the distance between the suction hole 31a and 31c. The alignment edge 214 is in the second assembled state arranged at an angle δ with respect to the x direction. The angle δ is smaller than 90 degrees, in this example shown the angle δ is 45 degrees. A substrate 32 may be positioned on the printing surface 24 by urging an edge 322 of the substrate 32 against said alignment edge 214, wherein said edge 322 of the substrate 32 attains an angle δ with respect to the x direction.

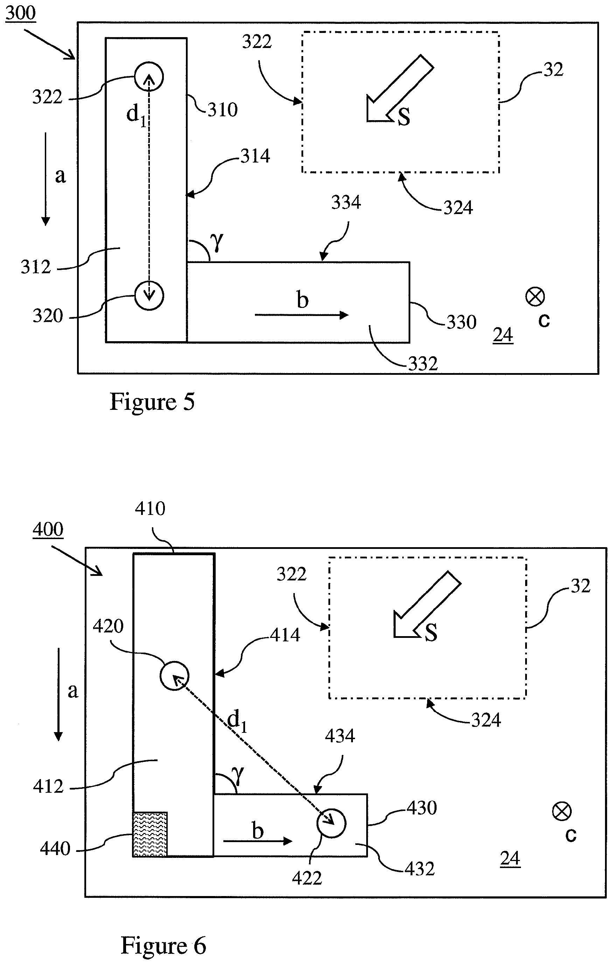

Fig. 5 shows a top view of an aligning anchor according to another embodiment of the present invention. The aligning anchor 300 comprises a first aligning element 310, which comprises a first contact surface 312 and a first alignment edge 314, a second aligning element 330, which comprises a second contact surface 332 and a second alignment edge 334, a first positioning pin 320 and a second positioning pin 322. The first positioning pin 320 and the second positioning pin 322 are arranged protruding from the first contact surface 312 in a direction as indicated by arrow c and have a mutual distance d₁ between them. The first contact surface 312 and the first alignment edge 314 extend in a first direction as indicated by arrow a. The second contact surface 332 and the second alignment edge 334 extend in a second direction as indicated by arrow b. The second alignment edge 334 has an angle γ with respect to the first alignment edge 314, which is substantially 90 degrees. The first contact surface 312 and the second contact surface 332 are arranged adjacent to each other and cooperatively have a substantially flat shape to contact a printing surface 24 in case the aligning anchor 300 is supported on the printing surface 24.
In case the aligning anchor 300 is supported on the printing surface 24 in an assembled state a substrate 32 may be positioned on said printing surface by aligning a first edge 322 of the substrate against the first alignment edge 314 and aligning a second edge 324 of the substrate against the second alignment edge 334.

Fig. 6 shows a top view of an aligning anchor according to another embodiment of the present invention. The aligning anchor 400 is a modified embodiment of the aligning anchor 300 shown in Fig. 5. The aligning anchor 400 comprises a first aligning element 410, which comprises a first contact surface 412 and a first alignment edge 414, a second aligning element 430, which comprises a second contact surface 432 and a second alignment edge 434, a first positioning pin 420 and a second positioning pin 422. The first positioning pin 420 arranged protruding from the first contact surface 412 in the direction c and the second positioning pin 422 is arranged protruding from the second contact surface 432 in the direction c. The first positioning pin 420 is arranged at a distance d₁ from the second positioning pin 422 in the plane of the first contact surface 412.
In case the aligning anchor 400 is supported on a printing surface in an assembled state a substrate 32 may be positioned on said printing surface by aligning a first edge 322 of the substrate against the first alignment edge 414 and aligning a second edge 324 of the substrate against the second alignment edge 434.

The first aligning element 410 further comprises a recess 440, which is arranged at the first contact surface 412 adjacent to a side of the first aligning element 410, such as the example shown arranged at a corner of the first aligning element 410. Said recess 440 is shaped for removing the aligning anchor from the printing surface 24. By arranging a flat tip, such as a fingernail, in the recess 440 between the aligning anchor 400 and the printing surface 24, the aligning anchor 400 may be easily removed from the printing surface 24.

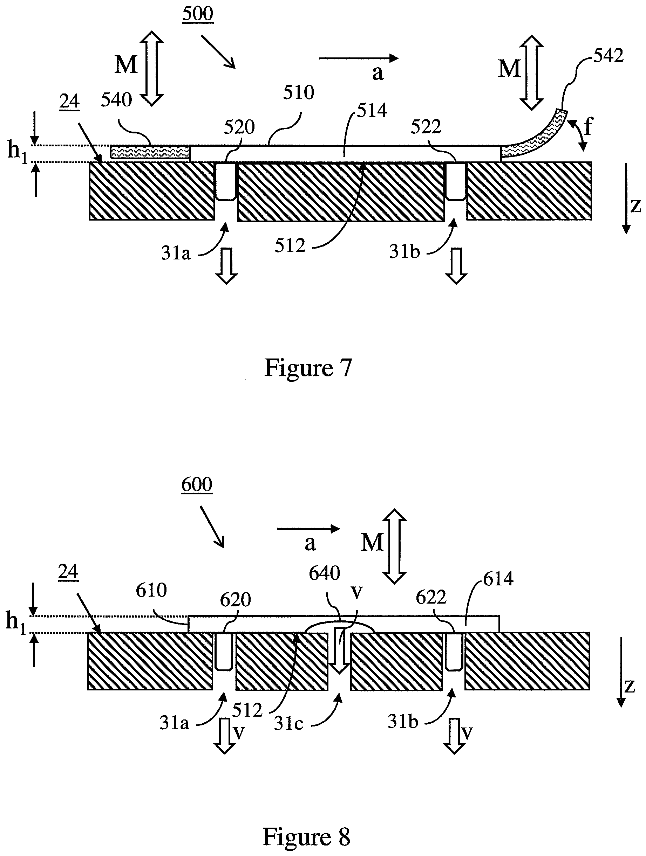

Fig. 7 shows an aligning anchor according to another embodiment of the present invention in an assembled state on a printing surface. The aligning anchor 500 comprises a first aligning element 510, a first positioning pin 520 and a second positioning pin 522. The first aligning element 510 comprises a contact surface 512 and an alignment edge 514. Fig. 7 is a view along a cross section line intersecting the first positioning pin 520 and the second positioning pin 522 and intersecting a first suction hole 31a and a second suction hole 31b of the printing surface 24 perpendicular to the printing surface 24. The aligning anchor 500 is positioned on the printing surface 24 as indicated by arrow M by supporting the contact surface 512 on the printing surface 24 and fitting the first positioning pin 520 into the first suction hole 31a of the printing surface 24 and fitting the second positioning pin 522 into the second suction hole 31b of the printing surface 24. The aligning anchor 500 further comprises two handle elements 540, 542 which are connected to the first aligning element 510. Each handle element 540, 542 comprises a flexible lip, which flexible lip extends substantially parallel to the contact surface 510 and is bendable at a loose end in a direction opposite to the protruding direction of the positioning pins 520, 522 as indicated by arrow f. The aligning anchor 500 may be removed from the printing surface 24 by bending the flexible lip and pulling the aligning anchor 500 at the flexible lip away from the printing surface 24 as indicated by arrows M. Both handle elements 540, 542 in a non-bended shape do not extend beyond a thickness of the first aligning element h1 perpendicular to the contact surface 512. As such the handle elements 540, 542 in the assembled state do not restrict an object, such as a print head, moving over the first aligning element 510.

Fig. 8 shows an aligning anchor according to another embodiment of the present invention in an assembled state on a printing surface. The aligning anchor 600 comprises a first aligning element 610, a first positioning pin 620 and a second positioning pin 622. The first aligning element 610 comprises a contact surface 612 and an alignment edge 614. Fig. 8 is a view along a cross section line intersecting the first positioning pin 620 and the second positioning pin 622 and intersecting a first suction hole 31a, a second suction hole 31b and a third suction hole 31c of the printing surface 24 perpendicular to the printing surface 24. The aligning anchor 600 is positioned on the printing surface 24 as indicated by arrow M by supporting the contact surface 612 on the printing surface 24 and fitting the first positioning pin 620 into the first suction hole 31a of the printing surface 24 and fitting the second positioning pin 622 into the second suction hole 31b of the printing surface 24. The aligning anchor 600 further comprises a cavity 640, which is arranged at the contact surface 612 facing the third suction hole 31c. The cavity 640 is enclosed by the contact surface 612 and is arranged in fluid communication to a suction source via the third suction hole 31c as indicated by arrow v. As such the cavity 640 forms a vacuum chamber in case a suction pressure is provided inside the third suction hole 31c.Thereby the aligning anchor 600 is fixed to the printing surface 24 due to the suction force pulling on the first aligning element 610 inside the cavity 640 towards the printing surface 24. In case the suction pressure is relieved in the cavity 640 the aligning anchor 600 may be removed from the printing surface 24.

Detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. In particular, features presented and described in separate dependent claims may be applied in combination and any advantageous combination of such claims are herewith disclosed.
Further, the terms and phrases used herein are not intended to be limiting; but rather, to provide an understandable description of the invention. The terms "a" or "an", as used herein, are defined as one or more than one. The term plurality, as used herein, is defined as two or more than two. The term another, as used herein, is defined as at least a second or more. The terms including and/or having, as used herein, are defined as comprising (i.e., open language). The term coupled, as used herein, is defined as connected, although not necessarily directly.

The invention is defined by the following claims.

## Claims

1. A printing apparatus (30) for providing an image on a substrate (32), the printing apparatus comprising a printing surface (24) for supporting the substrate in a printing area and an aligning anchor (100, 200) for positioning the substrate on the printing surface, the printing surface comprising a plurality of suction holes (31) being distributed over the printing surface to provide a suction force to a contact side of the substrate, the aligning anchor comprising:
a first aligning element (110, 210, 310, 410, 510, 610) comprising a contact surface (112, 212, 312, 412, 512, 612) shaped to contact the printing surface, wherein the first aligning element has a thickness (h₁) perpendicular to the contact surface; and
wherein the aligning anchor further comprises a first positioning pin (120, 220, 224, 320, 420, 520, 620) and a second positioning pin (122, 222, 322, 422, 522, 622), each positioning pin protruding in a height direction (c) substantially perpendicular from the contact surface and being shaped to fit into a suction hole, the first positioning pin and the second positioning pin being arranged at a distance (d₁, d₂, d₄) with respect to each other in the plane of the contact surface such that the first positioning pin fits into a first suction hole (31a) of the printing surface while the second positioning pin fits into a second suction hole (31b) of the printing surface in an assembled state of the aligning anchor and the printing surface.

2. The printing apparatus of claim 1, wherein the first aligning element comprises a first alignment edge (114, 214, 314, 414, 514, 614) disposed at one end of the contact surface, the first alignment edge extending in a first direction (a) and being shaped to accommodate a first edge (322) of the substrate along a first contact line.

3. The printing apparatus of claim 1, wherein each of the first positioning pin and the second positioning pin have a protruding part (121, 123, 227), which protruding part is conformed to substantially shut the respective suction hole of the printing surface in an assembled state of the aligning anchor and the printing surface.

4. The printing apparatus of claim 1, wherein the thickness of the first aligning element is at most equal to a predetermined print gap height.

5. The printing apparatus of claim 1, wherein the first positioning pin is movable into a plurality of positions in the plane of the contact surface to adjust the distance between the first positioning pin and the second positioning pin, wherein the aligning anchor comprises at least one recess (230) arranged to retain said first positioning pin in each of said plurality of positions.

6. The printing apparatus of claim 5, wherein said at least one recess comprises a groove (230) to guide said first positioning pin between each of said plurality of positions.

7. The printing apparatus of claim 2, wherein the aligning anchor further comprises a second aligning element (330, 430) comprising a second contact surface (332, 432) shaped to contact the printing surface, the second aligning element comprising a second alignment edge (334, 434) disposed at one end of the second contact surface, the second alignment edge extending in a second direction (b) and being shaped to accommodate a second edge (324) of the substrate along a second contact line, which second direction is arranged at an angle to the first direction.

8. The printing apparatus of claim 1, wherein the aligning anchor further comprises a handle element (540, 542), which handle element is adapted for manually positioning the aligning anchor onto the printing surface and/or manually removing the aligning anchor from the printing surface.

9. The printing apparatus of claim 8, wherein the handle element comprises a flexible lip, which flexible lip extends substantially parallel to the contact surface.

10. The printing apparatus of claim 8, wherein the handle element is detachable from the aligning anchor.

11. The printing apparatus of claim 1, wherein the first aligning element comprises a cavity (640) arranged at the contact surface to form a vacuum chamber arranged in fluid communication to a third suction hole of the printing surface in an assembled state of the aligning anchor and the printing surface.

12. The printing apparatus of claim 1, wherein the aligning anchor comprises a magnetic portion to magnetically attract the aligning anchor to the printing surface.

13. A printing apparatus according to any one of the claims 1 - 12, wherein each suction hole is arranged in fluid communication to a suction device, which is configured to provide a suction pressure to each of the plurality of suction holes; wherein the printing apparatus comprises a printing station comprising a print head assembly arranged at a predetermined print gap height and configured to apply ink dots on the substrate in the printing area; wherein the contact surface is arranged in contact with the printing surface and wherein each positioning pin of the aligning anchor is arranged in a respective suction hole of the printing surface, thereby determining a position of the aligning anchor with respect to the printing surface.

14. The printing apparatus according to claim 13, wherein the anchor has a marked part, wherein the printing apparatus further comprises a sensor device, which is configured to detect the marked part of the aligning anchor arranged on the printing surface and to provide a detection signal to a control unit, which is configured to derive the position and/or size of the substrate on the printing surface based on the detected position of the aligning anchor and is configured to control the printing of the image on the substrate based on the determined position and/or size of the substrate.

15. A method of handling a substrate on a printing surface, the method comprising the steps of:
a) Providing a printing apparatus according to any one of the claims 1-12;
b) Positioning the aligning anchor onto the printing surface, thereby supporting the contact surface on the printing surface and fitting each of the first and second positioning pins of said aligning anchor in a respective suction hole of the printing surface; and
c) Positioning the substrate on the printing surface, comprising supporting the contact side of the substrate on the printing surface and urging a respective edge of the substrate against the aligning anchor.

## Patentansprüche

1. Druckgerät (30) zum Erzeugen eines Bildes auf einem Substrat (32), wobei das Druckgerät eine Druckoberfläche (24) zur Aufnahme des Substrats in einem Druckbereich und einen Ausrichtanker (100, 200) zum Positionieren des Substrats auf der Druckoberfläche aufweist, wobei die Druckoberfläche eine Vielzahl von Sauglöchern (31) aufweist, die über die Druckoberfläche verteilt sind, um eine Saugkraft auf eine Kontaktseite des Substrats auszuüben, wobei der Ausrichtanker aufweist:
ein erstes Ausrichtelement (110, 210, 310, 410, 510, 610) mit einer Kontaktfläche (112, 212, 312, 412, 512, 612), die so geformt ist, dass sie die Druckoberfläche berührt, wobei das erste Ausrichtelement eine Dicke (h₁) rechtwinklig zu der Kontaktfläche hat, und wobei der Ausrichtanker weiterhin einen ersten Positionierstift (120, 220, 224, 230, 420, 520, 620) und einen zweiten Positionierstift (122, 222, 322, 422, 522, 622) aufweist, jeder Positionierstift in einer Höhenrichtung (c) im wesentlichen rechtwinklig von der Kontaktfläche vorspringt und so geformt ist, dass er in ein Saugloch passt, wobei der erste Positionierstift und der zweite Positionierstift in einem Abstand (d₁, d₂, d₄) relativ zueinander in der Ebene der Kontaktfläche angeordnet sind, derart, dass in einem zusammengebauten Zustand des Ausrichtankers und der Druckoberfläche der erste Positionierstift in ein erstes Saugloch (31a) der Druckoberfläche passt, während der zweite Positionierstift in ein zweites Saugloch (31b) der Druckoberfläche passt.

2. Druckgerät nach Anspruch 1, bei dem das erste Ausrichtelement eine erste Ausrichtkante (114, 214, 314, 414, 514, 614) aufweist, die an einem Ende der Kontaktfläche angeordnet ist, wobei sich die erste Ausrichtkante in einer ersten Richtung (a) erstreckt und so geformt ist, dass sie eine erste Kante (322) des Substrats entlang einer ersten Kontaktlinie aufnimmt.

3. Druckgerät nach Anspruch 1, bei dem jeder der ersten und zweiten Positionierstifte einen vorstehenden Teil (121, 123, 227) hat, der so geformt ist, dass er das betreffende Saugloch in der Druckoberfläche in einem zusammengebauten Zustand des Ausrichtankers und der Druckoberfläche im wesentlichen verschließt.

4. Druckgerät nach Anspruch 1, bei dem die Dicke des ersten Ausrichtelements höchstens gleich einer vorgegebenen Druckspalthöhe ist.

5. Druckgerät nach Anspruch 1, bei dem der erste Positionierstift in der Ebene der Kontaktoberfläche in eine Vielzahl von Positionen bewegbar ist, um den Abstand zwischen dem ersten Positionierstift und dem zweiten Positionierstift einzustellen, wobei der Ausrichtanker wenigstens eine Ausnehmung (230) aufweist, die dazu eingerichtet ist, den ersten Positionierstift in jeder der mehreren Positionen zu halten.

6. Druckgerät nach Anspruch 5, bei dem die wenigstens eine Ausnehmung eine Nut (230) zum Führen des ersten Positionierstiftes zwischen jeder der mehreren Positionen aufweist.

7. Druckgerät nach Anspruch 2, bei dem der Ausrichtanker weiterhin ein zweites Ausrichtelement (330, 430) aufweist, mit einer zweiten Kontaktfläche (332, 432), die dazu geformt ist, die Druckoberfläche zu berühren, wobei das zweite Ausrichtelement eine zweite Ausrichtkante (334, 434) aufweist, die an einem Ende der zweiten Kontaktfläche angeordnet ist, die zweite Ausrichtkante sich in einer zweiten Richtung (b) erstreckt und so geformt ist, dass sie eine zweite Kante (324) des Substrats entlang einer zweiten Kontaktlinie aufnimmt, wobei die zweite Richtung in einem Winkel zu der ersten Richtung angeordnet ist.

8. Druckgerät nach Anspruch 1, bei dem der Ausrichtanker weiterhin ein Griffelement (540, 542) aufweist, welches Griffelement dazu ausgebildet ist, den Ausrichtanker manuell auf der Druckoberfläche zu positionieren und/oder den Ausrichtanker manuell von der Druckoberfläche zu entfernen.

9. Druckgerät nach Anspruch 8, bei dem das Griffelement eine flexible Lippe aufweist, welche flexible Lippe sich im wesentlichen parallel zu der Kontaktfläche erstreckt.

10. Druckgerät nach Anspruch 8, bei dem das Griffelement von dem Ausrichtanker lösbar ist.

11. Druckgerät nach Anspruch 1, bei dem das erste Ausrichtelement einen Hohlraum (640) aufweist, der an der Kontaktfläche angeordnet ist, um eine Vakuumkammer zu bilden, die in einem zusammengebauten Zustand des Ausrichtankers und der Druckoberfläche mit einem dritten Saugloch der Druckoberfläche in Fluidverbindung steht.

12. Druckgerät nach Anspruch 1, bei dem der Ausrichtanker einen magnetischen Teil zum magnetischen Anziehen des Ausrichtankers gegen die Druckoberfläche aufweist.

13. Druckgerät nach einem der Ansprüche 1 bis 12, bei dem jedes Saugloch in Fluidverbindung mit einer Saugeinrichtung steht, die dazu konfiguriert ist, einen Saugdruck an jedem der mehreren Sauglöcher bereitzustellen, wobei das Druckgerät eine Druckstation mit einer Druckkopfanordnung aufweist, die in einer bestimmten Druckspalthöhe angeordnet und dazu konfiguriert ist, Tintenpunkte in dem Druckbereich auf das Substrat aufzubringen, wobei die Kontaktfläche mit der Druckoberfläche in Kontakt steht und wobei jeder Positionierstift des Ausrichtankers in einem jeweiligen Saugloch der Druckoberfläche angeordnet ist und dadurch eine Position des Ausrichtankers in Bezug auf die Druckoberfläche bestimmt.

14. Druckgerät nach Anspruch 13, bei dem der Anker einen markierten Teil hat, wobei das Druckgerät weiterhin eine Sensoreinrichtung aufweist, die dazu konfiguriert ist, den markierten Teil des Ausrichtankers zu detektieren, der auf der Druckoberfläche angeordnet ist, und ein Detektionssignal an eine Steuereinheit zu liefern, die dazu konfiguriert ist, die Position und/oder Größe des Substrats auf der Druckoberfläche auf der Basis der detektierten Position des Ausrichtankers zu bestimmen, und die dazu konfiguriert ist, das Drucken des Bildes auf das Substrat auf der Grundlage der bestimmten Position und/oder Größe des Substrats zu steuern.

15. Verfahren zum Handhaben eines Substrats auf einer Druckoberfläche, welches Verfahren die folgenden Schritte umfasst:
a) bereitstellen eines Druckgerätes nach einem der Ansprüche 1 bis 12;
b) positionieren des Ausrichtankers auf der Druckoberfläche, um dadurch die Kontaktfläche auf der Druckoberfläche abzustützen und jeden der ersten und zweiten Positionierstifte des Ausrichtankers in ein jeweiliges Saugloch der Druckoberfläche einzupassen; und
c) positionieren des Substrats auf der Druckoberfläche, mit abstützen der Kontaktseite des Substrats auf der Druckoberfläche und andrücken einer jeweiligen Kante des Substrats gegen den Ausrichtanker.

## Revendications

1. Appareil d'impression (30) pour fournir une image sur un substrat (32), l'appareil d'impression comprenant une surface d'impression (24) pour supporter le substrat dans une zone d'impression et un ancrage d'alignement (100, 200) pour positionner le substrat sur surface d'impression, la surface d'impression comprenant une pluralité de trous d'aspiration (31) étant répartis sur la surface d'impression pour fournir une force d'aspiration à un côté de contact du substrat, l'ancrage d'alignement comprenant :
un premier élément d'alignement (110, 210, 310, 410, 510, 610) comprenant une surface de contact (112, 212, 312, 412, 512, 612) mise en forme pour entrer en contact avec la surface d'impression, dans lequel le premier élément d'alignement a une épaisseur (h₁) perpendiculaire à la surface de contact ; et dans lequel l'ancrage d'alignement comprend en outre une première broche de positionnement (120, 220, 224, 320, 420, 520, 620) et une seconde broche de positionnement (122, 222, 322, 422, 522, 622), chaque broche de positionnement faisant saillie dans une direction de hauteur (c) sensiblement perpendiculaire à la surface de contact et étant mise en forme pour s'ajuster dans un trou d'aspiration, la première broche de positionnement et la seconde broche de positionnement étant disposées à une distance (d₁, d₂, d₄) l'une de l'autre dans le plan de la surface de contact de sorte que la première broche de positionnement s'ajuste dans un premier trou d'aspiration (31a) de la surface d'impression tandis que la seconde broche de positionnement s'ajuste dans un deuxième trou d'aspiration (31b) de la surface d'impression dans un état assemblé de l'ancrage d'alignement et la surface d'impression.

2. Appareil d'impression selon la revendication 1, dans lequel le premier élément d'alignement comprend un premier bord d'alignement (114, 214, 314, 414, 514, 614) disposé à une première extrémité de la surface de contact, le premier bord d'alignement s'étendant dans une première direction (a) et étant mis en forme pour recevoir un premier bord (322) du substrat le long d'une première ligne de contact.

3. Appareil d'impression selon la revendication 1, dans lequel chacune de la première broche de positionnement et de la seconde broche de positionnement comporte une partie faisant saillie (121, 123, 227), laquelle partie faisant saillie est conformée pour obturer sensiblement le trou d'aspiration respectif de la surface d'impression dans un état assemblé de l'ancrage d'alignement et de la surface d'impression.

4. Appareil d'impression selon la revendication 1, dans lequel l'épaisseur du premier élément d'alignement est au plus égale à une hauteur d'intervalle d'impression prédéterminée.

5. Appareil d'impression selon la revendication 1, dans lequel la première broche de positionnement peut être déplacée dans une pluralité de positions dans le plan de la surface de contact pour ajuster la distance entre la première broche de positionnement et la seconde broche de positionnement, dans lequel l'ancrage d'alignement comprend au moins un évidement (230) agencé pour retenir ladite première broche de positionnement dans chacune de ladite pluralité de positions.

6. Appareil d'impression selon la revendication 5, dans lequel ledit au moins un évidement comprend une rainure (230) pour guider ladite première broche de positionnement entre chacune de ladite pluralité de positions.

7. Appareil d'impression selon la revendication 2, dans lequel l'ancrage d'alignement comprend en outre un second élément d'alignement (330, 430) comprenant une seconde surface de contact (332, 432) mise en forme pour venir en contact avec la surface d'impression, le second élément d'alignement comprenant un second bord d'alignement (334, 434) disposé à une première extrémité de la seconde surface de contact, le second bord d'alignement s'étendant dans une seconde direction (b) et étant mis en forme pour recevoir un second bord (324) du substrat le long d'une seconde ligne de contact, laquelle seconde direction est agencée sur un angle par rapport à la première direction.

8. Appareil d'impression selon la revendication 1, dans lequel l'ancrage d'alignement comprend en outre un élément de poignée (540, 542), lequel élément de poignée est adapté pour positionner manuellement l'ancrage d'alignement sur la surface d'impression et/ou retirer manuellement l'ancrage d'alignement de la surface d'impression.

9. Appareil d'impression selon la revendication 8, dans lequel l'élément de poignée comprend une lèvre souple, laquelle lèvre souple s'étend sensiblement parallèlement à la surface de contact.

10. Appareil d'impression selon la revendication 8, dans lequel l'élément de poignée peut être détaché de l'ancrage d'alignement.

11. Appareil d'impression selon la revendication 1, dans lequel le premier élément d'alignement comprend une cavité (640) agencée au niveau de la surface de contact pour former une chambre à vide agencée en communication de fluide avec un troisième trou d'aspiration de la surface d'impression dans un état assemblé de l'ancrage d'alignement et de la surface d'impression.

12. Appareil d'impression selon la revendication 1, dans lequel l'ancrage d'alignement comprend une partie magnétique pour attirer magnétiquement l'ancrage d'alignement vers la surface d'impression.

13. Appareil d'impression selon l'une quelconque des revendications 1 à 12, dans lequel chaque trou d'aspiration est agencé en communication de fluide avec un dispositif d'aspiration, qui est configuré pour fournir une pression d'aspiration à chacun de la pluralité de trous d'aspiration ;
dans lequel l'appareil d'impression comprend un poste d'impression comprenant un ensemble de têtes d'impression agencé à une hauteur d'intervalle d'impression prédéterminée et configuré pour appliquer des points d'encre sur le substrat dans la zone d'impression ; dans lequel la surface de contact est agencée en contact avec la surface d'impression et dans lequel chaque broche de positionnement de l'ancrage d'alignement est agencée dans un trou d'aspiration respectif de la surface d'impression, en déterminant ainsi une position de l'ancrage d'alignement par rapport à la surface d'impression.

14. Appareil d'impression selon la revendication 13, dans lequel l'ancrage comporte une partie marquée, dans lequel l'appareil d'impression comprend en outre un dispositif capteur, qui est configuré pour détecter la partie marquée de l'ancrage d'alignement agencée sur la surface d'impression et pour fournir un signal de détection à une unité de commande, laquelle est configurée pour déduire la position et/ou la taille du substrat sur la surface d'impression en fonction de la position détectée de l'ancrage d'alignement et qui est configurée pour commander l'impression de l'image sur le substrat en fonction de la position et/ou la taille déterminée du substrat.

15. Procédé de manipulation d'un substrat sur une surface d'impression, le procédé comprenant les étapes consistant à :
a) fournir un appareil d'impression selon l'une quelconque des revendications 1 à 12 ;
b) positionner l'ancrage d'alignement sur la surface d'impression, en supportant ainsi la surface de contact sur la surface d'impression et en ajustant chacune des première et seconde broches de positionnement dudit ancrage d'alignement dans un trou d'aspiration respectif de la surface d'impression ; et
c) positionner le substrat sur la surface d'impression, γ compris le support du côté de contact du substrat sur la surface d'impression et la poussée d'un bord respectif du substrat contre l'ancrage d'alignement.
